# FASCICULE DE BREVET EUROPEEN

(11) **EP 0 897 182 B1**
(45) Date de publication et mention de la délivrance du brevet: **02.07.2003**
(21) Numéro de dépôt: 98410090.9
(22) Date de dépôt: 10.08.1998
(51) Int. Cl.: G11C 11/412

(54) **Cellele mémoire statique insensible aux rayonnements**
Strahlungsunempfindliche statische Speicherzelle
Static memory cell insensitive to radiation

(30) Priorité: 12.08.1997 FR 9710454
(43) Date de publication de la demande: 17.02.1999
(73) Titulaire: STMicroelectronics S.A., 92120 Montrouge (FR)
(72) Inventeur: Bessot, Denis, 38190 Brignoud (FR)
(74) Mandataire: de Beaumont, Michel

(56) Documents cités:
- FR-A- 2 702 874
- US-A- 5 111 429

## Description

L'invention concerne les cellules mémoire statiques et, plus particulièrement, des cellules mémoire dont l'état n'est pas modifié par la collision d'un ion lourd sur une zone sensible de la cellule.

Des équipements électroniques peuvent, dans certaines conditions, notamment dans l'espace, être soumis à des bombardements de particules, en particulier des ions lourds. Lorsque le drain d'un transistor de type MOS polarisé d'une manière déterminée est traversé par un ion lourd, le transistor MOS génère une impulsion parasite sur son drain. Un tel phénomène de perturbation, couramment appelé phénomène de "upset", peut entraîner des effets gênants, notamment changer l'état de la cellule mémoire par suite de l'action de l'impulsion parasite sur divers transistors de la cellule.

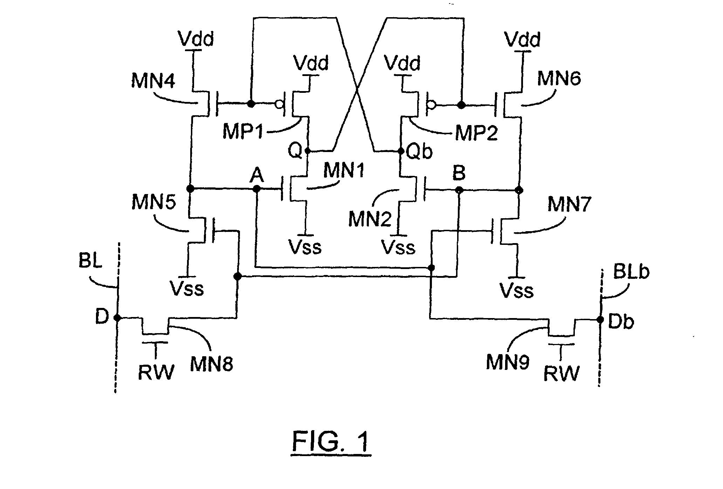

La demande internationale WO 94/22144 illustre page 1 - ligne 15 à page 3-ligne 26, figures 1A et 1B, une cellule mémoire statique classique. Elle comprend des transistors de type MOS formant deux inverseurs montés tête-bêche. Ces transistors permettent de mémoriser un état logique binaire et son état complémentaire. La cellule comprend en outre deux lignes d'accès pour lire ou écrire dans la cellule. Les inverseurs sont alimentés par un potentiel d'alimentation haut Vdd et par un potentiel d'alimentation bas Vss. Chaque inverseur est formé par un transistor à canal P et un transistor à canal N, montés en série. Les sources des transistors à canal P et à canal N reçoivent, respectivement, le potentiel Vdd et le potentiel Vss. Leurs drains sont reliés entre eux et forment la sortie de l'inverseur. Leurs grilles de commande sont reliées entre elles et forment l'entrée de l'inverseur. Un état logique haut, noté "1", correspondra à un potentiel sensiblement égal au potentiel d'alimentation haut Vdd. Un état logique bas, noté "0", correspondra à un potentiel sensiblement égal au potentiel d'alimentation bas Vss.

Les transistors sensibles sont, de manière générale, les transistors à canal N à l'état bloqué, dont le drain est à un potentiel proche du potentiel d'alimentation haut Vdd, et les transistor à canal P à l'état bloqué, dont le drain est à un potentiel proche du potentiel d'alimentation bas Vss. Dans le cas d'un transistor à canal N, si un ion lourd traverse la zone déplétée située au voisinage du drain, une impulsion négative est générée, et le potentiel de celui-ci est momentanément tiré vers le potentiel Vss. Inversement, dans le cas d'un transistor à canal P, une impulsion parasite positive est générée sur son drain, et le potentiel de celui-ci est momentanément tiré vers le potentiel Vdd. Il existe alors un risque de modification des états des transistors formant la cellule mémoire, et une modification de l'état de la donnée mémorisée dans cette cellule. Pour minimiser ce risque de modification, on a cherché à réaliser des cellules mémoire dites durcies, qui soient insensibles aux radiations.

Une première solution est de nature technologique et vise à réaliser des transistors intrinsèquement insensibles aux effets des radiations. Un inconvénient posé par ce type de solution est qu'elle est généralement difficile à mettre en oeuvre. Elle est également coûteuse, car il est nécessaire de développer et de mettre en production des technologies particulières.

Une deuxième solution, proposée dans le brevet américain 5 111 429, consiste à utiliser des mémoires redondantes. Cette solution présente deux inconvénients importants. Elle engendre une augmentation significative de la surface de silicium, à capacité de mémorisation égale. Elle engendre également une consommation importante.

Une troisième solution, proposée par exemple dans la demande WO 94/22144, consiste à modifier l'architecture des cellules mémoires pour minimiser le risque de modification des états mémorisés. Typiquement, la modification de l'architecture consiste en l'ajouts de transistors supplémentaires (au nombre de six, pour la demande WO 94/22144). Cette troisième solution présente donc généralement un inconvénient en terme de surface de silicium occupée et de courant consommé.

Un objet de l'invention est de proposer une cellule mémoire durcie présentant une faible probabilité de corruption lors de bombardements d'ions lourds.

Un autre objet de l'invention est de proposer une cellule qui soit relativement peu coûteuse en surface de silicium.

Un autre objet de l'invention est de proposer une cellule qui consomme peu.

Pour ce faire, on propose de modifier l'architecture classique de cellule mémoire en ajoutant seulement quatre transistors à canal N. L'invention s'inscrit ainsi dans une amélioration de la troisième solution.

Ainsi l'invention propose une cellule mémoire statique pour mémoriser, sous forme différentielle, une donnée présente sur au moins une ligne de donnée. La donnée est mémorisée sous forme différentielle dans deux ensembles, sur deux noeuds complémentaires de mémorisation associés aux ensembles. Cette donnée est accessible par le biais de deux noeuds complémentaires d'entrée/sortie associés aux ensembles. L'un au moins de ces noeuds d'entrée/sortie est accessible depuis la ligne de donnée pour lire et/ou écrire la donnée. Les deux ensembles comprennent chacun des premier et deuxième transistors reliés en série entre des premier et deuxième potentiels d'alimentation. Le premier transistor et le deuxième transistor sont de type différent. Les deux noeuds de mémorisation sont formés par les points de connexion entre les premier et deuxième transistors des deux ensembles. Le noeud de sortie de chaque ensemble est formé par une électrode de commande du deuxième transistor de l'autre ensemble. Le noeud de mémorisation de chaque ensemble est connecté à une électrode de commande du premier transistor de l'autre ensemble. Les deux ensembles comprennent un troisième transistor du même type que le deuxième transistor. Le troisième transistor est relié entre le premier potentiel d'alimentation et une électrode de commande du deuxième transistor de l'ensemble. Une électrode de commande de ce troisième transistor est reliée au noeud de mémorisation de l'autre ensemble. Les deux ensembles comprennent un quatrième transistor du même type que le deuxième transistor. Le quatrième transistor de chaque ensemble est relié entre le deuxième potentiel d'alimentation et une électrode de commande du deuxième transistor de l'ensemble. Une électrode de commande de ce quatrième transistor est reliée au noeud de sortie de l'ensemble.

Selon un mode de réalisation, la cellule comprend un transistor d'accès relié entre la ligne de donnée et le noeud d'entrée/sortie de l'un des ensembles. Une électrode de commande de ce transistor d'accès reçoit un signal de lecture/écriture.

Selon un mode de réalisation, la cellule comprend deux transistors d'accès reliés entre, d'une part, la ligne de donnée et une ligne de donnée complémentaire et, d'autre part, les noeuds d'entrée/sortie des ensembles. Une électrode de commande de ces transistors d'accès reçoit un signal de lecture/écriture.

Selon un mode de réalisation, le premier transistor de chaque ensemble est de type MOS à canal P, et les deuxième, troisième et quatrième transistors de chaque ensemble sont de type MOS à canal N.

D'autres avantages et particularités apparaîtront à la lecture de la description qui suit d'un exemple de réalisation de l'invention, à lire conjointement à la figure 1 qui présente un exemple de cellule mémoire selon l'invention.

### 1 - Structure de la cellule mémoire.

La figure 1 présente un exemple de cellule mémoire selon l'invention, réalisée en technologie MOS.

La cellule comprend un premier et un deuxième ensembles. Chaque ensemble comprend un premier et un deuxième transistors de type MOS, respectivement à canal P et à canal N, montés en série entre un potentiel d'alimentation haut Vdd et un potentiel d'alimentation bas Vss.

Deux noeuds complémentaires de mémorisation Q et Qb, associés aux ensembles, permettent de mémoriser sous forme différentielle une donnée binaire D. Cette donnée D est mémorisée sous forme différentielle. Le noeud Q mémorise l'état de la donnée D. Le noeud Qb mémorise l'état d'une donnée complémentaire Db, cet état étant l'inverse de l'état de la donnée D. Un état logique haut, noté "1", correspondra à un potentiel sensiblement égal au potentiel d'alimentation haut Vdd. Un état logique bas, noté "0", correspondra à un potentiel sensiblement égal au potentiel d'alimentation bas Vss.

Deux noeuds complémentaires d'entrée/sortie B et A, associés respectivement au premier et deuxième ensembles, permettent d'écrire et de lire les données D et Db mémorisées dans la cellule. Le noeud d'entrée/sortie A permet d'écrire et de lire l'état de la donnée D. Le noeud d'entrée/sortie B permet d'écrire et de lire l'état de la donnée complémentaire Db. Dans l'exemple illustré, ces données sont fournies aux noeuds d'entrée/sortie (et reçues, lors des lectures) par une ligne de donnée BL et une ligne de donnée complémentaire BLb. Ces lignes de donnée sont reliées respectivement aux noeuds B et A. Les lignes de donnée BL et BLb permettent de fournir ou recevoir, respectivement, les données D et Db. On pourra, comme on le verra par la suite, n'utiliser qu'une seule ligne de donnée pour accéder à la cellule mémoire, ce qui permet de limiter l'encombrement occupé par cette cellule et par les dispositifs de lecture et d'écriture associés.

Le premier ensemble comprend un premier transistor MP1, à canal P, et un deuxième transistor MN1, à canal N. La source du transistor MP1 reçoit le potentiel d'alimentation haut Vdd. Le drain du transistor MP1 est relié au drain du transistor MN1. La source du transistor MN1 reçoit le potentiel d'alimentation bas Vss. Le noeud de mémorisation Q est le point de connexion des transistors MP1 et MN1, ce point de connexion correspondant aux drains de ces transistors.

Le deuxième ensemble comprend un premier transistor MP2, à canal P, et un deuxième transistor MN2, à canal N. La source du transistor MP2 reçoit le potentiel d'alimentation haut Vdd. Le drain du transistor MP2 est relié au drain du transistor MN2. La source du transistor MN2 reçoit le potentiel d'alimentation bas Vss. Le noeud de mémorisation Qb est le point de connexion des transistors MP2 et MN2, ce point de connexion correspondant aux drains de ces transistors.

Il importe, comme on le verra plus loin, que la conductance des transistors MN1 et MN2 soit supérieure à celle des transistors MP1 et MP2. On choisira en conséquence les rapports de largeur de canal sur longueur de canal. Ce rapport pourra par exemple être le même pour tous ces transistors, compte tenu de la plus grande conductance des transistors à canal N, à dimension égale. Par ailleurs, pour assurer une symétrie des ensembles, on choisira des transistors MP1 et MP2, d'une part, et MN1 et MN2, d'autre part, qui aient des caractéristiques semblables.

Le premier ensemble comprend également des troisième et quatrième transistors MN4 et MN5, à canal N, montés en série entre le potentiel d'alimentation haut Vdd et le potentiel d'alimentation bas Vss. Le transistor MN4 reçoit le potentiel Vdd sur son drain. La source du transistor MN4 est relié au drain du transistor MN5 et à l'électrode de commande (encore appelée grille de commande) du transistor MN1. L'électrode de commande du transistor MN4 est reliée, d'une part, à l'électrode de commande du transistor MP1 et, d'autre part, au noeud de mémorisation du deuxième ensemble, Qb. L'électrode de commande du transistor MN5 est reliée à l'électrode de commande du transistor MN2. Le noeud d'entrée/sortie A du deuxième ensemble est formé par la source et le drain des transistors MN4 et MN5.

Le deuxième ensemble comprend également des troisième et quatrième transistors MN6 et MN7, à canal N, montés en série entre le potentiel d'alimentation haut Vdd et le potentiel d'alimentation bas Vss. Le transistor MN6 reçoit le potentiel Vdd sur son drain. La source du transistor MN6 est reliée au drain du transistor MN7 et à l'électrode de commande du transistor MN2. L'électrode de commande du transistor MN6 est reliée, d'une part, à l'électrode de commande du transistor MP2 et, d'autre part, au noeud de mémorisation Q. L'électrode de commande du transistor MN7 est reliée à l'électrode de commande du transistor MN1. Le noeud d'entrée/sortie B est le noeud formé par la source et le drain des transistors MN6 et MN7.

En notant 2W/L le rapport largeur/longueur de canal des transistors MN1 et MN2, on pourra choisir des transistors MN5 et MN7 de rapport 2W/L et des transistors MN4 et MN6 de rapport inférieur (par exemple de rapport W/L = 1/2 * 2W/L). Autrement dit, la conductance des transistors MN4 et MN6 est inférieure à celle des transistors MN5 et MN7. De même que pour les couples de transistors (MP1, MP2) et (MN1, MN2), on choisira des transistors MN4 et MN6, d'une part, et MN5 et MN7, d'autres part, qui aient des caractéristiques semblables. On assure ainsi une symétrie des ensembles formant la cellule mémoire.

Par rapport à une cellule mémoire classique, on différencie les commandes des transistors formant, dans une cellule classique, les inverseurs montés tête-bêche. Dans une cellule classique, on confond les noeuds de mémorisation et les noeuds d'entrée/sortie.

Dans la cellule de l'invention, les drains des transistors MP1 et MP2 sont reliés aux noeud Q et Qb, qui font office de noeuds de mémorisation des données D et Db mémorisées. Les transistors MN1 et MN2 sont commandés par les noeuds A et B, qui font office de noeuds d'entrée/sortie. On différencie donc les noeuds de mémorisation et les noeuds d'entrée/sortie. Comme on le verra par la suite, le noeud de mémorisation qui est à l'état haut contrôle le maintien à l'état haut du noeud d'entrée/sortie correspondant. Ce dernier contrôle le maintien à l'état bas de l'autre noeud d'entrée/sortie et de l'autre noeud de mémorisation. Ce second noeud de mémorisation participe au maintien à l'état haut du premier noeud de mémorisation.

La cellule de mémorisation comprend, enfin, deux transistors d'accès MN8 et MN9. Ces transistors reçoivent, sur leurs électrodes de commande, un signal de lecture/écriture RW qui permet de les rendre passants ou bloqués. Dans l'exemple illustré, les transistors MN8 et MN9 sont des transistors à canal N. Par conséquent, ils sont passants lorsque le signal RW est à l'état haut et bloqués sinon. On pourra éventuellement utiliser des transistors à canal P comme transistors d'accès.

Le canal du transistor d'accès MN8 est monté entre le noeud d'entrée/sortie B et la ligne de donnée BL. Le canal du transistor d'accès MN9 est monté entre le noeud d'entrée/sortie A et la ligne de donnée complémentaire BLb.

### 2 - Lecture de la donnée D.

### 2.1 - Lecture d'un "0".

On va supposer que l'on souhaite lire une donnée stockée dans la cellule mémoire, cette donnée étant caractérisée par Q = 0 et Qb = 1.

Comme on a Q = 0, le transistor MP2 est passant, ce qui maintient Qb à 1. Le transistor MP1 est donc bloqué. Le transistor MN6 est également bloqué.

Le transistor MN4 est passant. Le noeud A est au potentiel Vdd - Vt, en notant Vt la tension de seuil du transistor MN4. Les transistors MN1 et MN7 sont donc passants (en supposant, bien entendu, que Vdd - Vt est supérieur aux tensions de seuil des transistors MN1 et MN7). Le transistor MN7 étant passant, le potentiel du noeud d'entrée/sortie B est sensiblement égal au potentiel Vss. Les transistors MN2 et MN5 sont donc bloqués.

Pour lire les données complémentaires D et Db mémorisées dans la cellule mémoire, on rend les transistors d'accès passants en positionnant le signal RW à l'état haut. On va alors relier les lignes de donnée BL et BLb aux noeuds d'entrée/sortie B et A, dont les potentiels sont représentatifs des états de D et Db. En effet, en négligeant les pertes induites par les transistors de la cellule mémoire, les potentiels des noeuds Q et B sont sensiblement égaux, de même que les potentiels Qb et A. Ainsi, la ligne BL va être amenée au potentiel Vss et la ligne BLb va être amenée au potentiel Vdd - Vt.

### 2.2 - Lecture d'un "1".

On ne décrira pas en détail cet exemple. Il suffit de se reporter à l'exemple ci-dessus, en considérant que les transistors bloqués sont alors passants, et inversement.

### 3 - Ecriture de la donnée D.

On va maintenant s'intéresser à l'écriture dans la cellule mémoire.

Comme on le verra, ce sont principalement les transistors MN1 et MN2 qui sont utilisés pour modifier la donnée différentielle stockée.

### 3.1 - Ecriture d'un "0".

On va supposer que l'on souhaite stocker D = 0 dans la cellule mémoire (on a alors Db = 1).

Si la donnée précédemment présente était un "0", il n'y aura aucune modification dans la cellule, les noeuds restant alors au potentiel qu'ils occupaient avant l'écriture.

On va supposer que la donnée précédemment mémorisée était un "1". On a alors Q = 1 et Qb = 0. Le potentiel du noeud A est égal à Vss, et le potentiel du noeud B est proche de Vdd. Les transistors MP1, MN6, MN2 et MN5 sont passants. Les transistors MP2, MN4, MN1 et MN7 sont bloqués.

Pour modifier l'état des noeuds Q et Qb, il faut rendre passants les transistors MN1 et MP2, et bloquer les transistors MP1 et MN2. Pour cela, on positionne la ligne BL au potentiel Vss et la ligne BLb au potentiel Vdd. Puis on rend les transistors d'accès passants.

Lorsque le transistor MN8 devient passant, le potentiel du noeud B a tendance à être ramené à Vss par le biais du transistor d'accès MN8. Le transistor MN6 a tendance, par contre, à maintenir le potentiel du noeud B Vdd - Vt. Typiquement, les lignes de données sont reliées à des transistors qui permettent d'imposer l'état "1" ou l'état "0" sur ces lignes, lorsque l'on souhaite écrire une donnée dans la cellule. Pour ce faire, on pourra par exemple relier les lignes de donnée à des inverseurs CMOS classiques, formés d'un transistor à canal P et d'un transistor à canal N. Si la donnée mémorisée précédemment à l'écriture est l'inverse de la donnée à écrire, on va ramener le potentiel d'un des noeuds d'entrée/sortie de la cellule à une valeur proche de Vss. En supposant que la ligne de donnée reliée à ce noeud est reliée à Vss par le biais d'un transistor à canal N, on pourra montrer qu'il suffit, pour que les états mémorisés dans la cellule puissent être modifiés, que les rapports largeur/longueur de canal de ce transistor à canal N et du transistor d'accès correspondants à cette ligne soient égaux à celui du transistor MN4 ou MN6 correspondant à ce noeud.

Le transistor MN5 se bloque lorsque son électrode de commande reçoit un potentiel inférieur à sa tension de seuil.

Le potentiel du noeud A peut alors augmenter, par le biais du transistor MN4, et le transistor MN1 devient passant. Le potentiel du noeud Q a alors tendance à diminuer. Le transistor MP1 s'oppose au transistor MN1. Néanmoins, la conductance du transistor MN1 étant supérieure, le potentiel du noeud Q va être amené au niveau de Vss. En conséquence, le transistor MP2 va devenir passant et le transistor MN6, au contraire, va se bloquer.

Parallèlement au transistor MN1, le transistor MN7 est rendu passant. Le transistor MN7 ayant une conductance supérieure à celle du transistor MN6, ce transistor va amener le potentiel du noeud B au niveau de Vss, ce qui bloque le transistor MN2. Le transistor MN2 ne pouvant plus s'opposer au transistor MP2, le potentiel de Qb va augmenter pour atteindre Vdd. Le transistor MP1 va donc se bloquer et, parallèlement, le transistor MN4 va amener le potentiel du noeud A à Vdd - Vt.

Le transistor MN4 va maintenir l'état du noeud A lorsque le transistor MN9 sera ultérieurement bloqué, en fin d'écriture. Le transistor MN7 va maintenir l'état du noeud B lorsque le transistor MN8 sera ultérieurement bloqué, en fin d'écriture.

### 3.2 - Ecriture d'un "1".

De même que précédemment, si la donnée stockée était déjà un "1", il n'y a pas de modification dans la cellule de mémorisation.

Si la donnée mémorisée était un "0", il suffira de se reporter à l'exemple ci-dessus en inversant les états des transistors et des noeuds.

### 4 - Perturbation de la cellule.

On va maintenant s'intéresser au comportement de la cellule mémoire lors d'une perturbation, en s'intéressant plus particulièrement aux noeuds Q et A. La structure de la cellule étant symétrique, on étendra sans peine les exemples décrits au cas de perturbations sur les noeuds Qb et B.

### 4.1 - Impulsion positive sur le noeud Q.

Supposons que l'on ait Q = 0 et Qb = 1, et qu'une perturbation positive apparaisse sur le noeud de mémorisation Q. Cette perturbation va se traduire par une impulsion positive parasite sur ce noeud, c'est-à-dire par une brusque augmentation du potentiel sur le drain du transistor MP1.

Le transistor MP2 va se bloquer. Le noeud Qb est alors flottant et maintient l'état "1" par effet capacitif. Parallèlement, le transistor MN6 devient transitoirement passant et le potentiel du noeud B augmente légèrement. Dans la mesure où la conductance du transistor MN7 est supérieure à celle du transistor MN6, cette augmentation du potentiel du noeud B est insuffisante pour atteindre le seuil de conduction du transistor MN2, et ceci indépendamment de la durée ou de l'amplitude de l'impulsion positive. Le potentiel du noeud Qb n'est donc pas modifié, une fois l'impulsion disparue par décharge du noeud Q au travers du transistor MN1.

Le transistor MN7 étant passant lors de l'impulsion, il s'oppose à l'augmentation du potentiel du noeud B. Il pourra par ailleurs être d'autant plus passant que l'amplitude de l'impulsion parasite sera supérieure à Vdd. En effet, dans ce cas, le potentiel sur le drain du transistor MP1 est supérieur au potentiel sur son électrode de commande. Le potentiel Vdd va donc avoir tendance à augmenter, par décharge du noeud Q au travers du transistor MP1. De ce fait, le potentiel du noeud A va augmenter également, ce qui peut induire une augmentation de la conductance du transistor MN7, si cette conductance n'était pas déjà maximale.

### 4.2 - Impulsion négative sur le noeud Q.

Supposons que l'on ait Q = 1 et Qb = 0, et qu'une perturbation négative apparaisse sur le noeud Q. Cette perturbation va se traduire par une impulsion négative parasite sur ce noeud, c'est-à-dire par une brusque diminution du potentiel sur le drain du transistor MN1. Ce potentiel pourra éventuellement devenir inférieur au potentiel Vss.

Le transistor MP2 va devenir passant et le transistor MN6 va se bloquer. Le potentiel du noeud Qb va alors avoir tendance à augmenter. Le potentiel du noeud B étant maintenu par effet capacitif, le transistor MN2 reste passant. La conductance du transistor MN2 étant supérieure à celle du transistor MP2, le noeud Qb va être maintenu à un potentiel proche du potentiel Vss lorsque le transistor MP2 est passant. Le transistor MP1 va donc rester passant, ce qui permet de ramener le noeud Q à son potentiel initial.

De même que précédemment, on pourra assister à une diminution du potentiel Vss, si le potentiel sur le drain du transistor MN1 devient inférieur au potentiel de son électrode de commande. Il y a alors inversion temporaire des drains et sources du transistor MN1.

### 4.3 - Impulsion négative sur le noeud A.

Supposons que l'on ait Q = 0 et Qb = A = 1, et qu'une perturbation négative apparaisse sur le noeud A. Cette perturbation va se traduire par une impulsion négative parasite sur ce noeud, c'est-à-dire par une brusque diminution du potentiel sur le drain du transistor MN5. Ce potentiel pourra éventuellement devenir inférieur au potentiel Vss.

Les transistors MN7 et MN1 vont se bloquer. Les noeuds Q et B sont alors flottants et maintiennent leur état antérieur par effet capacitif. Autrement dit, les transistors MP2 et MN2 restent, respectivement, passant et bloqué. Par conséquent le potentiel du noeud Qb n'est pas modifié et le transistor MN4 est maintenu à l'état passant. On va donc assister à rétablissement du potentiel du noeud A, par le biais de ce transistor MN4.

L'hypothèse d'une impulsion positive sur un noeud d'entrée/sortie ne sera pas étudiée. En effet, les troisièmes et quatrièmes transistors des ensembles étant à canal N, une collision avec un ion lourd ne peut engendrer un tel phénomène.

En conclusion, la cellule selon l'invention, dans laquelle on différencie les noeuds de mémorisation et les noeuds d'entrée/sortie, présente une très bonne résistance aux bombardements ioniques. Un risque de modification du contenu de la cellule peut éventuellement se présenter si deux ions lourds heurtent simultanément deux noeuds sensibles de la cellule. Toutefois, la probabilité qu'un tel événement se produise est infime.

Par ailleurs, on notera que la cellule est particulièrement avantageuse en terme de surface occupée et de consommation. En ce qui concerne la surface de la cellule, on ne rajoute que quatre transistors pour se prémunir contre les effets des bombardements. En ce qui concerne la consommation, elle apparaît uniquement de façon transitoire, lorsque l'on écrit dans la cellule ou lorsqu'une perturbation apparaît. La cellule n'induit pas de consommation statique.

### 5 - Cellule à un seul noeud d'entrée/sortie.

On pourra bien entendu modifier la structure particulière décrite sans pour autant sortir du cadre de l'invention, notamment en ce qui concerne les polarités et les tailles des transistors.

Une variante de la cellule décrite est, par exemple, d'utiliser la structure telle que décrite, mais en n'utilisant qu'une seule ligne de donnée. Cela revient à enlever la ligne de donnée complémentaire et le transistor d'accès correspondant, et à les remplacer par un inverseur. On peut ainsi disposer d'une cellule mémoire moins encombrante. On peut surtout réaliser des mémoires ou registres moins encombrants puisque l'on divise par deux le nombre de lignes de donnée et de dispositifs de lecture/écriture associés aux lignes de donnée.

On va supposer, à titre d'exemple, que l'on utilise uniquement la ligne de donnée BL et le transistor d'accès MN8. L'électrode de commande du transistor MN7 et le noeud A seront alors reliés à la sortie d'un inverseur dont l'entrée sera reliée au noeud B.

En ce qui concerne la lecture, on ne notera aucune différence notable vis-à-vis de ce qui a été décrit en référence à la figure 1.

En ce qui concerne l'écriture, on prendra soin au dimensionnement des transistors. En effet, pour la cellule de la figure 1, les transistors d'accès ont un canal N. La ligne de donnée qui va principalement enclencher le basculement des potentiels des noeuds est donc la ligne qui fournit un "0" à la cellule. Si l'on dispose d'une seule ligne de donnée, l'écriture d'un "0" ne posera donc pas de problème particulier. Par contre, si l'on souhaite écrire un "1", il conviendra de s'assurer que le dispositif fournissant ce "1" (typiquement il s'agira d'un transistor à canal P) a une conductance suffisante vis-à-vis du transistor MN7, qui a tendance à maintenir le potentiel du noeud B à une valeur proche de Vss. En effet, il convient que l'on puisse assurer un blocage du transistor MN5 si l'on veut pouvoir bloquer ledit transistor MN7.

Par ailleurs, si on utilise un inverseur CMOS classique, on va introduire un noeud sensible supplémentaire dans la cellule, sur le drain du transistor MOS à canal P de cet inverseur. Les impulsions parasites éventuelles sur ce noeud étant de type positives, il conviendra d'adapter en conséquence les tailles des transistors MP1 et MN1, pour éviter qu'une impulsion parasite ne puisse induire de changement des états mémorisés. En pratique, il conviendra de diminuer la conductance du transistor MN1.

On pourra bien entendu apporter différentes modifications à la cellule décrite, sans pour autant sortie du cadre de l'invention. A titre d'exemple, on pourra utiliser les noeuds A et B uniquement en entrée et utiliser des lignes de sortie de données reliées aux noeuds Q et Qb pour lire le contenu de la cellule. On pourra également utiliser un seul des noeuds Q ou Qb en noeud de sortie, si on utilise par exemple une seule ligne d'entrée, tel que mentionné ci-dessus.

## Revendications

1. Cellule mémoire statique pour mémoriser, sous forme différentielle, une donnée (D) présente sur au moins une ligne de donnée (BL),
- la donnée étant mémorisée sous forme différentielle dans deux ensembles, sur deux noeuds complémentaires de mémorisation (Q, Qb) associés aux ensembles, et cette donnée étant accessible par le biais de deux noeuds. complémentaires d'entrée/sortie (A, B) associés aux ensembles,
- l'un au moins de ces noeuds d'entrée/sortie (B) étant accessible depuis la ligne de donnée (BL) pour lire et/ou écrire la donnée,
- les deux ensembles comprenant chacun des premier et deuxième transistors (MP1, MN1; MP2, MN2) reliés en série entre des premier et deuxième potentiels d'alimentation (Vdd, Vss), le premier transistor (MP1, MP2) et le deuxième transistor (MN1, MN2) étant de type différent, et les deux noeuds de mémorisation étant formés par les points de connexion entre les premier et deuxième transistors des deux ensembles,
- le noeud de sortie (B, A) de chaque ensemble étant formé par une électrode de commande du deuxième transistor (MN2, MN1) de l'autre ensemble,
- le noeud de mémorisation (Q, Qb) de chaque ensemble étant connecté à une électrode de commande du premier transistor (MP2, MP1) de l'autre ensemble,
- les deux ensembles comprenant un troisième transistor (MN4, MN6) du même type que le deuxième transistor (MN1, MN2), le troisième transistor (MN4, MN6) étant relié entre le premier potentiel d'alimentation (Vdd) et une électrode de commande du deuxième transistor (MN1, MN2) de l'ensemble, et une électrode de commande de ce troisième transistor étant reliée au noeud de mémorisation (Qb, Q) de l'autre ensemble,
- les deux ensembles comprenant un quatrième transistor (MN5, MN7) du même type que le deuxième transistor (MN1, MN2), le quatrième transistor de chaque ensemble étant relié entre le deuxième potentiel d'alimentation (Vss) et une électrode de commande du deuxième transistor (MN1, MN2) de l'ensemble, et une électrode de commande de ce quatrième transistor étant reliée au noeud de sortie (B, A) de l'ensemble.

2. Cellule mémoire selon la revendication 1, **caractérisée en ce qu'**elle comprend un transistor d'accès (MN8, MN9) relié entre la ligne de donnée (BL, BLb) et le noeud d'entrée/sortie (B, A) de l'un des ensembles, une électrode de commande de ce transistor d'accès recevant un signal de lecture/écriture (RW).

3. Cellule mémoire selon la revendication 1, **caractérisée en ce qu'**elle comprend deux transistors d'accès (MN8, MN9) reliés entre, d'une part, la ligne de donnée (BL) et une ligne de donnée complémentaire (BLb) et, d'autre part, les noeuds d'entrée/sortie (B, A) des ensembles, une électrode de commande de ces transistors d'accès recevant un signal de lecture/écriture (RW).

4. Cellule mémoire selon l'une des revendications précédentes, **caractérisée en ce que** le premier transistor de chaque ensemble est de type MOS à canal P, et **en ce que** les deuxième, troisième et quatrième transistors de chaque ensemble sont de type MOS à canal N.

## Patentansprüche

1. Eine statische Speicherzelle zum Speichern, und zwar in Differentialform, eines Datums (D), das auf zumindest einer Datenleitung (BL) vorliegt,
- wobei das Datum gespeichert wird in Differentialform in zwei Sätzen, und zwar auf zwei komplementären Speicherknoten (Q, Qb), die den Sätzen zugeordnet sind, und wobei auf dieses Datum über zwei komplementäre Eingabe/Ausgabeknoten (A, B) zugegriffen werden kann, die den Sätzen zugeordnet sind,
- wobei auf zumindest einen dieser Eingabe/Ausgabeknoten (B) zugreifbar ist von der Datenleitung (BL) zum Lesen und/oder Schreiben des Datums,
- wobei beide Sätze jeweils erste und zweite Transistoren (MP1, MN1; MP2, MN2) aufweisen, die in Serie zwischen ersten und zweiten Versorgungspotentialen (Vdd, Vss) verbunden sind, wobei der erste Transistor (MP1, MP2) und der zweite Transistor (MN1, MN2) von unterschiedlichem Typ sind, und wobei die zwei Speicherknoten durch Verbindungsknoten zwischen den ersten und zweiten Transistoren der zwei Sätze gebildet sind,
- wobei der Ausgabeknoten (B, A) jedes Satzes gebildet ist durch eine Steuerelektrode des zweiten Transistors (MN2, MN1) des anderen Satzes,
- wobei der Speicherknoten (Q, Qb) jedes Satzes verbunden ist mit einer Steuerelektrode des ersten Transistors (MP2, MP1) des anderen Satzes,
- wobei beide Sätze einen dritten Transistor (MN4, MN6) vom gleichen Typ wie der des zweiten Transistors (MN1, MN2) aufweisen, wobei der dritte Transistor (MN4, MN6) verbunden ist zwischen dem ersten Versorgungspotential (Vdd) und einer Steuerelektrode des zweiten Transistors (MN1, MN2) des Satzes, und wobei eine Steuerelektrode des dritten Satzes verbunden ist mit dem Speicherknoten (Qb, Q) des anderen Satzes,
- wobei beide Sätze einen vierten Transistor (MN5, MN7) vom gleichen Typ wie der des zweiten Transistors (MN1, MN2) aufweisen, wobei der vierte Transistor jedes Satzes verbunden ist zwischen dem zweiten Versorgungspotential (Vss) und einer Steuerelektrode des zweiten Transistors (MN1, MN2) des Satzes, und wobei eine Steuerelektrode des vierten Transistors verbunden ist mit dem Ausgabeknoten (B, A) des Satzes.

2. Zelle nach Anspruch 1, **dadurch gekennzeichnet, dass** sie einen Zugriffstransistor (MN8, MN9) aufweist, der verbunden ist zwischen der Datenleitung (BL, BLb) und dem Eingabe/Ausgabeknoten (B, A) von einem der Sätze, wobei eine Steuerelektrode dieses Zugriffstransistors ein Lese/Schreibsignal (RW) empfängt.

3. Zelle nach Anspruch 1, **dadurch gekennzeichnet, dass** sie zwei Zugriffstransistoren (MN8, MN9) aufweist, die einerseits zwischen der Datenleitung (BL) und einer komplementären Datenleitung (BLb) verbunden sind und andererseits zwischen den Eingabe/Ausgabeknoten (B, A) des Satzes, wobei eine Steuerelektrode dieser Zugriffstransistoren ein Lese/Schreibsignal (RW) empfängt.

4. Zelle nach einem der vorhergehenden Ansprüche, **dadurch gekennzeichnet, dass** der erste Transistor von jedem Satz vom P-Kanal-MOS-Typ ist, und wobei die zweiten, dritten und vierten Transistoren eines jeden Satzes vom N-Kanal-MOS-Typ sind.

## Claims

1. A static memory cell to store, in differential form, a datum (D) present on at least one data line (BL),
- the datum being stored in differential form in two sets, on two complementary storage nodes (Q, Qb) associated with the sets, and this datum being accessible via two complementary input/output nodes (A, B) associated with the sets,
- one at least of these input/output nodes (B) being accessible from the data line (BL) to read and/or write the datum,
- both sets each including first and second transistors (MP1, MN1; MP2, MN2) connected in series between first and second supply potentials (Vdd, Vss), the first transistor (MP1, MP2) and the second transistor (MN1, MN2) being of different type, and the two storage nodes being formed by the connection nodes between the first and second transistors of the two sets,
- the output node (B, A) of each set being formed by a control electrode of the second transistor (MN2, MN1) of the other set,
- the storage node (Q, Qb) of each set being connected to a control electrode of the first transistor (MP2, MP1) of the other set,
- both sets including a third transistor (MN4, MN6) of same type as the second transistor (MN1, MN2), the third transistor (MN4, MN6) being connected between the first supply potential (Vdd) and a control electrode of the second transistor (MN1, MN2) of the set, and a control electrode of this third transistor being connected to the storage node (Qb, Q) of the other set,
- both sets including a fourth transistor (MN5, MN7) of same type as the second transistor (MN1, MN2), the fourth transistor of each set being connected between the second supply potential (Vss) and a control electrode of the second transistor (MN1, MN2) of the set, and a control electrode of this fourth transistor being connected to the output node (B, A) of the set.

2. The cell of claim 1, **characterized in that** it includes an access transistor (MN8, MN9) connected between the data line (BL, BLb) and the input/output node (B, A) of one of the sets, a control electrode of this access transistor receiving a read/write signal (RW).

3. The cell of claim 1, **characterized in that** it includes two access transistors (MN8, MN9) connected between, on the one hand, the data line (BL) and a complementary data line (BLb) and, on the other hand, the input/output nodes (B, A) of the sets, a control electrode of these access transistors receiving a read/write signal (RW).

4. The cell of one of the preceding claims, **characterized in that** the first transistor of each set is of P-channel MOS type, and the second, third, and fourth transistors of each set are of N-channel MOS type.
